# EUROPEAN PATENT APPLICATION

(11) **EP 2 175 500 A1**
(43) Date of publication of application: **14.04.2010**
(21) Application number: 08166385.8
(22) Date of filing: 10.10.2008
(51) Int. Cl.: H01L 35/34, H01L 35/22, H01L 35/32

(54) **Thermoelectric conversion elements, thermoelectric conversion modules and a production method of the thermoelectric conversion modules**

(71) Applicant: Ishikawa Prefectural Government, Kanazawa-shi Ishikawa 920-8203 (JP); Nikko Company, Hakusan-shi Ishikawa 924-8686 (JP); Actree Corporation, Hakusan-shi Ishikawa 924-0053 (JP)
(72) Inventor: Toyoda, Takeshi c/o Industrial Research Institute of Ishikawa, Kanazawa-shi Ishikawa 920-8203 (JP); Nakamura, Shizuo c/o Industrial Research Institute of Ishikawa, Kanazawa-shi Ishikawa 920-8203 (JP); Takimoto, Mikio, c/o Nikko Company, Hakusan-shi Ishikawa 924-8686 (JP); Kidani, Naoki, c/o Nikko Company, Hakusan-shi Ishikawa 924-8686 (JP); Kamei, Hiroshi, c/o Nikko Company, Hakusan-shi Ishikawa 924-8686 (JP); Mizukoshi, Hiroharu c/o Actree Corporation, Hakusan-shi Ishikawa 924-0053 (JP); Masui, Megumi, c/o Actree Corporation, Hakusan-shi Ishikawa 924-0053 (JP)
(74) Representative: Greenwood, John David

(57) **Abstract**

The present invention provides a thermoelectric conversion module, comprising plural first electrode films (11, 12, 13) formed apart from each other on the top surface of an insulating body (10), plural p- and n-type thermoelectric semiconductor element films (16, 19) and (17, 18) formed thereon, which are arranged apart from each other so that p- and n-type thermoelectric semiconductor element films alternate with each other, and second electrode films (20) connecting p-type thermoelectric semiconductor element film (19) and n-type thermoelectric semiconductor element film (18) over the gaps between the first electrode films; and a terminal electrode is connected to each of the p-and n-type thermoelectric semiconductor element film (16, 17) at the end; and a production method thereof. The thermoelectric conversion module of the present invention, which can be produced at a low cost using thermoelectric conversion elements having a thin-film structure, is excellent in thermal stability and chemical durability and enables to secure high thermoelectric conversion efficiency.

## Description

### CROSS-REFERENCE TO RELATED APPLICATIONS

This application incorporates complete content disclosed by the specification, drawings and abstract of Japanese Patent Application No. 2007-109210 filed on April 18, 2007.

### TECHNICAL FIELD

The present invention relates to thermoelectric conversion elements which convert a temperature differential between the front-side and the back-side of a substance into electrical energy and vice versa, thermoelectric conversion modules using the thermoelectric conversion elements and a production method thereof.

### BACKGROUND ART

Conventionally, a thermoelectric conversion system has been in practical use, which system converts thermal energy into electrical energy and vice versa by means of Seebeck effect and Peltier effect. In the thermoelectric conversion system, p- and n-type thermoelectric conversion semiconductors are used which are referred to as thermoelectric conversion elements. Generally, these elements generate small voltage per element. Therefore, a plurality of elements are connected in series so as to obtain practical power generation.

Conventionally, thermoelectric modules are produced by slicing ingot thermoelectric material into bulk thermoelectric elements and connecting them to each other on electrodes. Bulk thermoelectric elements are produced by high temperature casting, single-crystal zone-melting, powder sintering, etc. However, in conventional production of thermoelectric modules, top and bottom surfaces of each aligned element are sandwiched between insulating plates and a terminal is provided at the end of the insulating plate. Furthermore, the assembling process is difficult since the thermoelectric elements are produced by slicing to mount to the thermoelectric module with a pair of the pair-type n- and p-type thermoelectric segments. Thus, productivity is low and the cost is high.

Laid-Open Japanese Patent Publication No. 2006-49796 (U.S. Patent Publication No. 2006-118160) discloses a ceramics module and relates to a bonding method in production of a π-type module obtained by cutting ceramics having thermal stability and chemical durability.

U.S. Patent No. 6,127,619 discloses a thermoelectric conversion module which is manufactured by filling a paste mainly comprising organic resin obtained by adding thereto fine powder of thermoelectric semiconductors and conductive fine powder into the hole of a substrate, and by forming electrodes on top and bottom surfaces of the substrate after polishing and smoothing the surfaces. In this case, the adoption of a printing method of embedding the thermoelectric conversion semiconductor using a squeegee into a hole in the substrate is proposed.

Further, Laid-Open Japanese Patent Publication No. 2004-281726 (PCT Publication W02004/084321) describes a method of producing thin film thermoelectric modules having n- and p-type segments. In the method described the segments are manufactured by first forming a multilayer film by e.g. vapor-phase deposition (PVD). However, the process is very expensive and not very well suited for mass production.

PCT Publication WO2005/109535 describes a method of producing thin film thermoelectric device using solid or liquid paste. In the method described the segments are manufactured by wave printing or exposing UV-light curing techniques. The number of layers is 50 or more and a thickness of each layer is less than 1 micrometer. The multilayer structure provides interfaces between the layers which increase the electrical and thermal resistance.

### DISCLOSURE OF THE INVENTION

### PROBLEMS TO BE SOLVED BY THE INVENTION

The thermoelectric semiconductor element and the thermoelectric conversion module produced by the method of slicing ingot thermoelectric material into bulk thermoelectric elements as described above has a structure wherein p- and n-type thermoelectric semiconductor elements are alternately allocated and the terminals of the adjacent elements are combined to each other to achieve a series-connected structure. Accordingly, the module has disadvantages of troublesome production and a bulky shape. Furthermore, in the case of a ceramic thermoelectric conversion element, it becomes a complicated element since it introduces plural thermal buffering materials in order to alleviate detachment from the metal as an electrode due to the difference in coefficient of thermal expansion and to lower an electrical barrier, which makes the element unsuitable for industrial mass production.

Also, the structure according to U.S. Patent No. 6,127,619 requires a mechanical step for punching holes in the substrate. The structure requires a further step of making the thermoelectric conversion semiconductor element embedded in the hole of the substrate protrude from the hole so as to ensure the connection with the electrodes attached on the top and bottom surfaces of the substrate, for example, by embedding the element in the hole after a masking film is provided on the outer side of the hole and then polishing the top and bottom surfaces of the substrate and covering the entire protruded part of the semiconductor element with the electrode.

As mentioned above, p- and n-type thermoelectric conversion elements are planarly-bonded to the electrode in the same plane in the modular structure according to U.S. Patent No. 6,127,619, which involves a troublesome step for ensuring the connection and makes it difficult to make a thin structure as a whole due to the structure wherein the semiconductor elements are embedded in the hole in the substrate.

The method for laminating elements described in Laid-Open Japanese Patent Publication No. 2004-281726 (PCT Publication W02004/084321) is the vapor-phase depositing method (pulse laser) which requires a film-formation in vacuum and takes cost for the vapor-deposition equipment. (In the case of using an oxide, it is necessary to use a sintered body made of 100-percent-thermoelectric material or to use technology for forming a single-crystal film.) Also, the above-mentioned deposition treatment has a problem that p- and n-type elements cannot be subjected to the sintering treatment simultaneously in fabricating a module since the sintering temperatures of p- and n-type elements are different.

The present invention in its various aspects is as claimed in the claims.

Embodiments of the present invention provide thermoelectric conversion elements and thermoelectric conversion module having a thin-film structure and being excellent in thermal stability and chemical durability at low cost, which enable to maintain good Seebeck coefficient per thermoelectric conversion element and to secure high thermoelectric conversion efficiency, and a production method thereof to thereby solve the conventional problems such as a troublesome production step and difficulty in making a thin structure.

In one embodiment, a thermoelectric conversion element of the present invention is obtained by mixing powder of thermoelectric conversion material and a binder to make a paste and by curing the paste in a thin-film shape on the top surface of an electrode.

Other aspects of the present invention provide the following thermoelectric conversion element, thermoelectric conversion module and production method of the thermoelectric conversion module:
1. A thermoelectric conversion element obtained by curing a paste prepared by mixing powder of thermoelectric conversion material with a binder in a form of a thin film on the top surface of an electrode.
2. The thermoelectric conversion element as described in 1 above, wherein the thermoelectric conversion material is a synthesized oxide thermoelectric semiconductor and is obtained by curing the paste prepared by mixing the powder of the oxide thermoelectric semiconductor adjusted to have a particle size of 0.1 to 10 µm with a metal oxide as a binder at a rate of 0.5 to 50 mass% to the thermoelectric semiconductor into a form of a thin film on the top surface of an electrode.
3. The thermoelectric conversion element as described in 1 or 2 above, wherein the film thickness after sintering and curing is 1 to 100 µm.
4. The thermoelectric conversion element as described in 3 above, wherein the film thickness after sintering and curing is 10 to 20 µm.
5. A thermoelectric conversion module, comprising first electrode films formed on the top surface of an insulating body, p- and n-type thermoelectric conversion films formed apart from each other on the top surfaces of the first electrode films and second electrode films formed on the top surface of the p- and n-type thermoelectric conversion films, wherein either of the first and the second electrode films is divided between the p- and n-type thermoelectric conversion films.
6. A thermoelectric conversion module, comprising a plurality of first electrode films formed on the top surface of an insulating body, a plurality of p- and n-type thermoelectric conversion films formed alternately and apart from each other on the top surfaces of the first electrode films, and second electrode films which connect p- and n-type thermoelectric conversion element films so as to cross over the gap between the first electrode films, wherein each of p- and n-type thermoelectric conversion element films at the end is connected to a terminal electrode film.
7. The thermoelectric conversion module as described in 6 above, wherein a glass film is interposed in the gap between the first electrode films and between the p- and n-type thermoelectric conversion element films facing to the gap.
8. The thermoelectric conversion module as described in 6 or 7 above, wherein the p- and n-type thermoelectric conversion element films are the thermoelectric conversion element films made into a thin-film form having a thickness of 1 to 100 µm by curing a paste prepared by mixing the powder of the thermoelectric material with a binder.
9. The thermoelectric conversion module as described in 8 above, wherein the p- and n-type thermoelectric conversion element films are the thermoelectric conversion element films made into a thin-film form having a thickness of 10 to 20 µm by curing a paste prepared by mixing the powder of the thermoelectric material with a binder.
10. A method for producing a thermoelectric conversion module comprising a step of forming a plurality of first electrode films apart from each other on the top surface of an insulating body by screen-printing,
   a step of forming a glass film in the gap between the first electrode films,
   a step of forming p- and n-type thermoelectric conversion element films sandwiching the glass film on the first electrode film by screen-printing,
   a step of connecting the top surfaces of the p- and n-type thermoelectric conversion element films with a second electrode film crossing over the glass film by screen-printing, and
   a step of forming a terminal electrode film connecting to each of the p- and n-type thermoelectric conversion element films at the end which is not connected by the second electrode film.

As mentioned in the background art section of this application and the there-mentioned problems thereof, in the conventional technology, an ordinary sintered body subjected to high-pressure treatment (having a density of 95 % or higher) or a single-crystal is used as an oxide element in order to improve the electric conductivity (which leads to higher thermal conductivity). On the other hand, in the present invention, a gap between particles becomes wider since the sintered body is obtained by sintering fine powder of a thermoelectric material, which enables to achieve an effect of lowering the thermal conductivity. In the present invention, a rapid decline in the electric conductivity (30,000 mΩcm to 500 mΩcm) is observed only when a paste in which an oxide binder is mixed in an appropriate amount is used and a layer structure is controlled to have a thickness of 10 to 20 µm, and unexpected effects can be attained other than durability and integral molding by simultaneous sintering.

In an aspect of the present invention, an oxide material is used for thermoelectric conversion elements formed in a thin-film, which prevents performance degradation in the atmosphere and enables to attain a large temperature difference in the element. Since the thermoelectric conversion element of the present invention is much thinner than a conventional block of π-type devices made by being cut out from a ceramic plate, it can suppress the heat distortion and attain stable performance for a long period. Furthermore, since the element is made into a thin-film by screen printing, it can be printed not only on a flat surface but also on a curved surface, which reduces production costs and enables power generation using a large-area film and power generation using temperature difference as large as several tens of degrees at low cost.

The applications of the thin-film thermoelectric conversion module and thermoelectric conversion device of the present invention include power generation using temperature difference between the influent water (generally about 60 °C) and effluent water (about 15 to 20 °C) in an industrial water-cooling equipment and power generation using temperature difference between the wastewater, which becomes warm water, and the outdoor air or water at ordinary temperatures in a sewage treatment equipment and the like.

Besides, the module and device are applicable to power generation using the temperature difference between the internal exhaust gas and the outdoor air by being provided at the surface site of a member of an exhaust-gas treatment equipment (generally at 100°C or higher) in a heat-treating furnace such as an incinerator. The module and device also enable power generation by the temperature difference between the ground temperature and the outdoor temperature using air, water, ammonium and the like as a heat medium; power generation using the indoor-outdoor temperature difference by providing the module or the device on the outer wall of constructions; and power generation using the temperature difference between the indoor temperature and the glass temperature contacting with the outdoor air by providing the module or the device on the interior and exterior surfaces of the glass portions of a building and a greenhouse.

Furthermore, various applications can be expected such as power generation using the temperature difference between the fermentation temperature and the outdoor air or the service water in a composting facility as a biomass energy installation.

### BEST MODE FOR CARRYING OUT THE INVENTION

One, exemplary, embodiment of the present invention provides a thermoelectric conversion element having thermal electromotive force of 20 µV/K or more in a temperature range of 293 to 1073 K.

Another embodiment of the present invention provides a thermoelectric conversion element having electrical resistivity of 500 mΩcm or less in a temperature range of 293 to 1073 K.

The thermoelectric conversion module according to the present invention comprises a first electrode film formed on the top surface of an insulating body, p- and n-type thermoelectric conversion films formed apart from each other on the top surface of the first electrode film and a second electrode film on the top surfaces of the p- and n-type thermoelectric conversion films, wherein either of the first and the second electrode films is divided between the p- and n-type thermoelectric conversion films.

The thermoelectric conversion module in another embodiment of the present invention comprises a plurality of first electrode films formed on the top surface of an insulating body, a plurality of p- and n-type thermoelectric conversion films formed alternately and apart from each other on the top surfaces of the first electrode films, and second electrode films which connect p- and n-type thermoelectric conversion element films so as to cross over the gap between the first electrode films, wherein each of p- and n-type thermoelectric conversion element films at the end is connected to a terminal electrode film.

The present invention further provides a method for producing a thermoelectric conversion module, comprising a step of forming a plurality of first electrode films apart from each other on the top surface of an insulating body by screen-printing,
a step of forming a glass film in the gap between the first electrode films,
a step of forming p- and n-type thermoelectric conversion element films sandwiching the glass film on the first electrode film by screen-printing,
a step of connecting the top surfaces of the p- and n-type thermoelectric conversion element films with a second electrode film crossing over the glass film by screen-printing, and
a step of forming a terminal electrode film connecting to each of the p- and n-type thermoelectric conversion element films at the end which is not connected by the second electrode film.

### BRIEF DESCRIPTION OF DRAWINGS

An embodiment of the present invention will now be described, by way of example, only, with reference to the accompanying drawings, of which:
Figs. 1(A) and 1(B) are a plan view and a crosssectional view, respectively, of the thermoelectric conversion module in one embodiment of the present invention;
Figs. 2(A) and 2(B) are a plan view and a crosssectional view, respectively, of the thermoelectric conversion module in another embodiment of the present invention;
Figs. 3(A) and 3(B) are a plan view and a crosssectional view, respectively, of the thermoelectric conversion module (device) in still another embodiment of the present invention obtained by connecting a plurality of the basic-form thermoelectric conversion modules in Figs. 1 and Figs. 2 in series;
Figs. 4(A) to 4(D) are figures showing the production process of the thermoelectric module of Figs. 3;
Fig. 5(A)to 5(C) are figures showing the production method of a thermoelectric conversion module produced using transfer paper; and
Fig. ] is a plan view of a planar thermoelectric conversion device consisting of a plurality of band-shaped thermoelectric conversion modules aligned on the same plane.

### EXPLANATION OF REFERENCE NUMBER

- 1, 10, 31: (insulating ceramic) substrate
- 2, 11, 12, 13, 20: first electrode film
- 3, 16, 19, 27: p-type thermoelectric semiconductor element film
- 4, 17, 18, 28: n-type thermoelectric semiconductor element film
- 5, 14, 15: glass film
- 6, 7, 8, 20, 21, 23: second electrode film
- 22 paper coated by: water-soluble resin (transfer paper)
- 24: resin coating
- 25: laminated body
- 30: thermoelectric conversion module
- 32, 33: terminal electrode

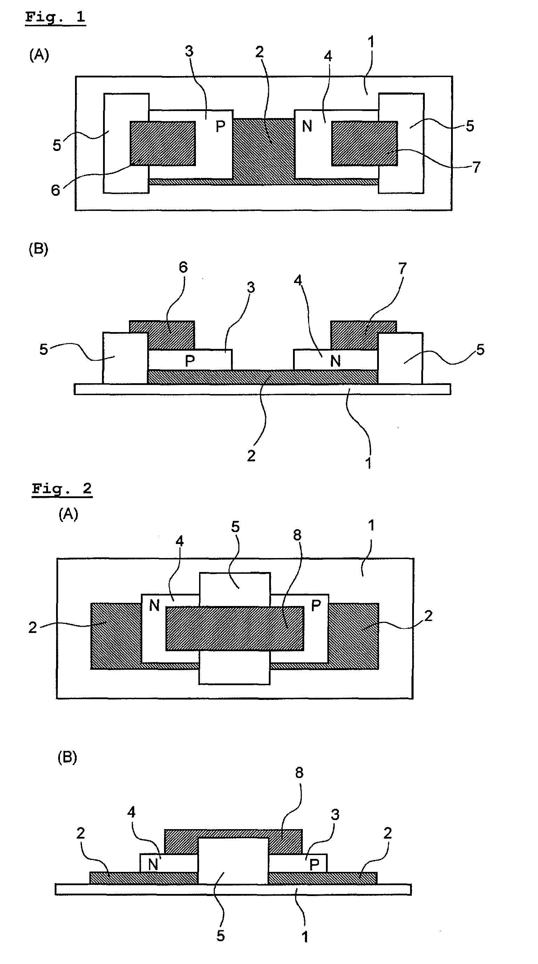

Referring to Figs. 1 (A) and (B), a first electrode film (2) is formed on the top surface of an insulating ceramic plate (1) containing nitride and silicon carbide having relatively good thermal conductivity, and a p-type thermoelectric semiconductor element film (3) and an n-type thermoelectric semiconductor element film (4) which serve as thermoelectric conversion elements are formed apart from each other on the top surface of the first electrode film (2). On the both ends of top surface of the substrate (1), a glass film (5) is attached adjacent to each of the p-type thermoelectric semiconductor element film (3) and n-type thermoelectric semiconductor element film (4), and further, second electrode films (6, 7) are formed so as to cross the top surfaces of the p-type thermoelectric semiconductor element film (3) and the glass film (5) as well as the top surfaces of the n-type thermoelectric semiconductor element film (4) and the glass film (5). The electrode films (6, 7) on each of the glass films (5) are respectively connected to a terminal electrode (not shown in the Figure) provided on the substrate (1). According to the structure, electromotive force arises between the terminal electrodes due to the temperature difference between the bottom surface of the substrate and the surface on the side of the second electrode film.

Referring to Figs. 2 (A)and(B), a first electrode films (2, 2) are formed apart from each other on the top surface of the same insulating substrate (1) as in Fig. 1, and a glass film (5) is formed on the top surface of the substrate and in the gap between the first electrode films (2, 2). A p-type thermoelectric semiconductor element film (3) and an n-type thermoelectric semiconductor element film (4) are formed apart from each other on the top surfaces of the first electrode films (2, 2). As shown in the figure, the p- and n-type thermoelectric semiconductor element films (3, 4) are separated from each other by the glass film (5) interposed therebetween. Further, a second electrode film (8) is formed crossing the glass film (5) so as to connect the p-type thermoelectric semiconductor element film (3) and the n-type thermoelectric semiconductor element film (4). On the substrate, each of the first electrode films (2, 2) is connected to a terminal electrode (not shown in the Figure) provided on the substrate (1) to thereby fabricate a thermoelectric conversion module. From this structure, electromotive force arises between the terminal electrodes in the same way as in the embodiment in Figs. 1 due to the temperature difference between the bottom surface of the substrate and the surface on the side of the second electrode film.

The thermoelectric conversion module in Figs. 1 or Figs. 2 is a basic form of the arrangement of the electrode films and p- and n-type thermoelectric semiconductor films of the present invention. Only a small value of electromotive force is generated from the structure consisting of the basic form, which is insufficient for practical use. Therefore, in practice, a plurality of the modules in the form of Figs. 1 or 2 are connected in a row and a plurality of the connected rows are further set parallel to each other to thereby join the ends of the rows in series and to fabricate a thermoelectric conversion device.

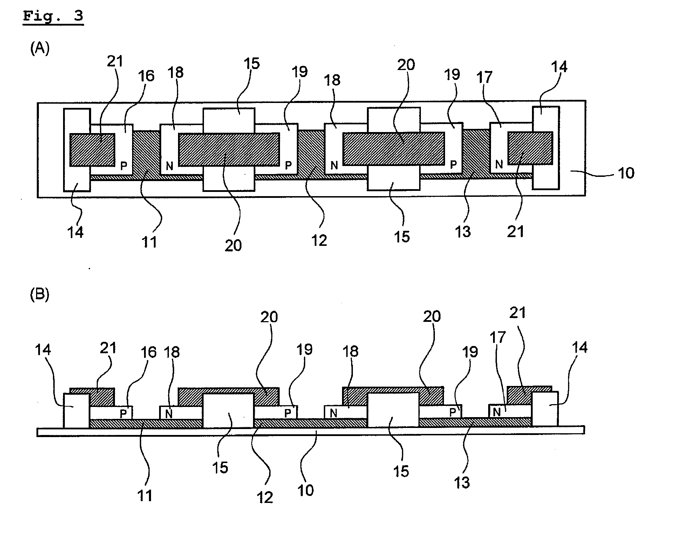

With reference to Figs. 3 (A) and (B), the thin-film type thermoelectric conversion module in this embodiment is explained. Three rectangular first electrode films (11, 12, 13) are formed on the top surface of an insulating ceramic substrate (10). Also, a glass film (14) serving as a heat insulating material is formed on each of the outer edges of the first electrode films (11, 13) and the similar glass film (15) is formed in the gap between the first electrode films (11, 12) and the gap between the first electrode films (12, 13) on the top surface of the substrate (10).

On the end of the top surfaces of the first electrode films (11, 13), p-type thermoelectric semiconductor element film (16) and n-type thermoelectric semiconductor element film (17) are formed respectively adjacent to a terminal glass film (14); and n-type thermoelectric semiconductor element films (18) and p-type thermoelectric semiconductor element films (19) are formed on the first electrode films (11, 12, 13) adjacent to the inside two glass films (15). These p- and n-type thermoelectric semiconductor element films (16, 19) and (17, 18) are arranged so that p- and n-type thermoelectric semiconductor element films alternate with each other from one end to the other end of the module.

The second electrode film (20) is formed crossing each of the glass substrates (15) so as to bridge n-type thermoelectric semiconductor element film (18) and p-type thermoelectric semiconductor element film (19) sandwiching the glass film (15) and a terminal electrode film (21) is formed on each of the top surfaces of the p-type thermoelectric semiconductor element film (16) and p-type thermoelectric semiconductor element film (17) at the end. The terminal electrode film (21) is connected to a terminal electrode provided on the substrate (10). Though the upper side of the thermoelectric conversion module, that is, the side of the second electrode film, is exposed, the face may be covered by an appropriate resin body or an insulating glass body. Due to the temperature difference between the bottom surface of the substrate and the side of the second electrode film, electromotive force is generated between the terminal electrodes.

In the embodiments shown in Figs. 1 to Figs. 3, the module has a film structure wherein the film thickness of the module except the substrate is 1 µm to 100 µm. Particularly, it is preferable to adjust the film thickness of the thermoelectric semiconductor film to approximately 10 to 20 µm. As the material of the thermoelectric semiconductor element, the one containing oxide and metal as an active ingredient can be used. Examples of the material for p- and n-type thermoelectric conversion elements include an oxide semiconductor material such as NaCO₂O₄, CaCo₄O₉, CaMnO₃, TiO₂, ZnO, SrTiO₃ and Fe₃O₄.

Components of a base material of the thermoelectric conversion material include, for example, NaCO₂O₄, CaCo₄O₉, CaMnO₃, TiO₂, ZnO, SrTiO₃ and Fe₃O₄ as p- and n-type thermoelectric conversion material, and thermally excited electric charge can be efficiently extracted by mixing metal or a semiconducting ceramics serving as a conductive path with the material.

As a binder to be added to powder of thermoelectric semiconductor elements as an additive of a screen printing paste, polymer or a solvent containing metal oxide or metal ion as an active ingredient can be used. Particularly preferable examples are those which turn to copper oxide at the time of sintering, such as copper salt of an organic acid, organic alkoxide (Cu), copper carbonate and copper sulfate. Besides, metal oxide such as CuO, Bi₂O₃, Cu₂O, PbO, LiO, Fe₂O₃ and Fe₃O₄ can be used alone or in combination of two or more thereof. Also, one or more kinds of H₃BO₃. Na₂CO₃ or Li-Bi-Si low-melting glass may be used.

The ratio of the binder is 0.5 to 50 mass% to the thermoelectric semiconductor element material. For example, when CuO is used as a binder, the desired proportion of CuO is 0.5 to 50 mass%, more preferably 5 to 40 mass% to the thermoelectric semiconductor element material.

As a material for the first and second electrode films, those which can be sintered under oxygen atmosphere such as Pt, Ag and Al are used. In the embodiments in Figs. 1 to Figs. 3, silver (Ag) is used.

Substrates which can be used in the present invention include a ceramic substrate containing nitride and silicon carbide having relatively good thermal conductivity and a metal plate having an insulated surface, for example, those made by providing a diffusion layer of alumina and nickel oxide on the surface of iron and made of break-proof materials and those subjected to so-called calorizing treatment through diffusion coating of aluminum alloy by blowing oxygen into a blast furnace. Besides, a ceramic thin plate and a ceramic tube, or, a glass plate and a glass tube may also be used.

### EXAMPLES

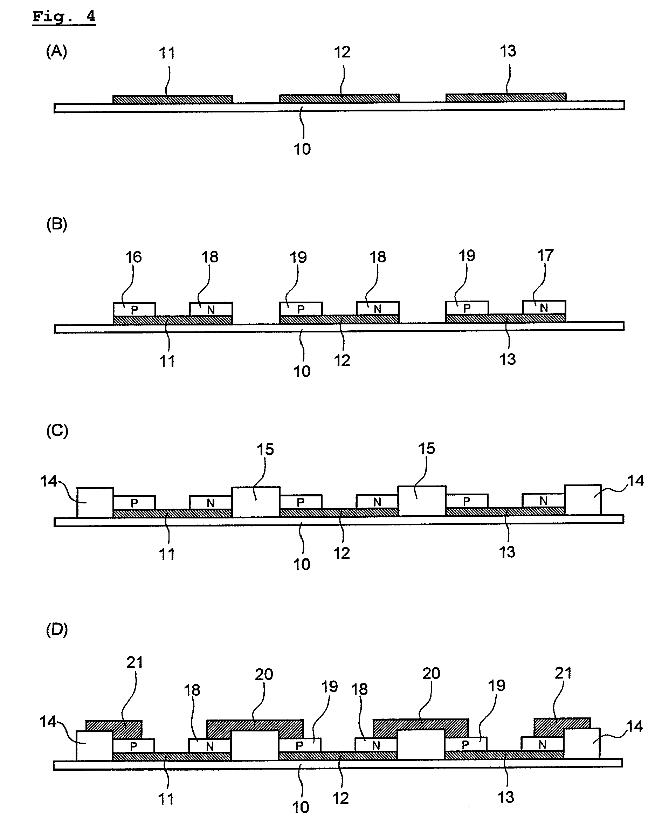

The production process of the thermoelectric conversion module in the embodiments of the present invention is described below with reference to Figs. 4 (A) to (D).

A thermoelectric semiconductor element was prepared for examples. A calcium-cobalt oxide thermoelectric material (Ca_{2.7}La_{0.3}Co₄O₉) as a material for p-type thermoelectric conversion elements was prepared as follows: Calcium carbonate (CaCO₃), lanthanum oxide (La₂O₃) and cobalt oxide (Co₃O₂) were measured to make determined compositions (Ca_{2.7}La_{0.3}Co₄O₉). After mixing and press molding the compounds, the mixture was calcined in the air flow (200 ml/min.) at 780°C for two hours and pulverized. After being subjected to pulverizing, mixing and press-molding again, the resultant was calcined in the air flow (200 ml/min.) at 800°C for three hours and pulverized. The resultant was press molded (at the pressure of 200 MPa) by CIP (cold isostatic press) and sintered in the air at 870°C for ten hours.

A calcium-manganese oxide thermoelectric material (Ca_{0.9}La_{0.1}MnO₃) as a material for n-type thermoelectric conversion elements was prepared as follows: Calcium carbonate (CaCO₃), lanthanum oxide (La₂O₃) and manganese oxide (MnO₂) were measured to make determined compositions (Ca_{0.9}La_{0.1}MnO₃). After mixing and press molding the compounds, the mixture was calcined in the air flow (200 ml/min.) at 800°C for one hour. After pulverizing by a ball mill, the resultant was press molded (at the pressure of 200 MPa) by CIP (cold isostatic press) and sintered in the air at 1200°C for ten hours.

The p- and n-type oxide semiconductors synthesized as mentioned above were pulverized by a ball mill for 18 to 24 hours to obtain fine powder having a particle diameter of 0.5 to 3 µm.

Metal oxide such as copper oxide (CuO) and bismuth oxide (Bi₂O₃) was added as a binder in the proportion of 0.5 to 50 mass%, preferably 5 to 40 mass% to each of the thermoelectric semiconductor fine powder. Also, resin such as ethyl cellulose and a solvent such as α-terpineol are added thereto in the appropriate amounts and the mixture was kneaded to be made into paste.

Next, on a lengthy ceramic substrate such as alumina (10) having determined dimensions, three units of the rectangular first electrode films (11, 12, 13) were screen-printed with silver paste apart from each other in the longitudinal direction and then sintered in the air at 850°C (Fig. 4 (A)). On the first electrode films (11 to 13), the above-mentioned p-type thermoelectric semiconductor element and n-type thermoelectric semiconductor element in paste form were pattern-printed by screen printing apart from each other so that p- and n-type elements are allocated alternately (Fig. 4 (B)). The film thickness is adjusted to 1 to 100 µm and the semiconductor elements may be overprinted twice or more, if desired. In this embodiment, three faces of each p- and n-type thermoelectric semiconductor element films (16 to 19) are provided and arranged alternately from the left in the figure in a row of p-type (on the extreme left), n-type, (snip) p-type and n-type (on the extreme right).

Subsequently, glass films (15) as a heat insulating material are printed between two pairs of p- and n-type thermoelectric semiconductor element films (18, 19) facing to the gap between the first electrode films (11) and (12) and that between the first electrode films (12) and (13). The glass film (14) as a heat insulating layer is also printed adjacent to and on the outside of each of the p-type thermoelectric semiconductor element film (16) at the end (at the far left) and n-type thermoelectric semiconductor element film (17) at the end (at the far right). Subsequently, second electrode films (21) are formed by screen-printing on the top surfaces of the p- and n-type thermoelectric semiconductor element films (16, 17) at both ends and over the glass films (14) at both ends, and so are second electrode films (20) bridging the n- and p-type thermoelectric semiconductor element films (18, 19) facing to the gaps between the first electrode films and over the two inside glass films (15), followed by sintering in the air at 850°C (Fig. 4 (D)). Each of the second electrode films allocated on the both ends (21) is connected to a terminal electrode laid on the end of the substrate.

The material in paste form after screen printing in the production process may be sintered after each printing as mentioned above, after all the printing steps are finished or after arbitrary number of printing. For a sintering method, sintering in a furnace using electricity, gas or fuel oil as heat source and high frequency sintering may be used. Three units of the first electrode films (11 to 13) and six units of p- and n-type thermoelectric semiconductor element films were formed on the substrate (10) in the embodiment in Fig. 4. However, it goes without saying that many more electrode films and thermoelectric semiconductor films may be formed in the longitudinal direction of the substrate (10).

The above-mentioned embodiment is an example of forming each electrode and thermoelectric conversion element on the plate-form substrate by screen printing. However, each constituent element also can be formed using transfer paper instead of a hard substrate.

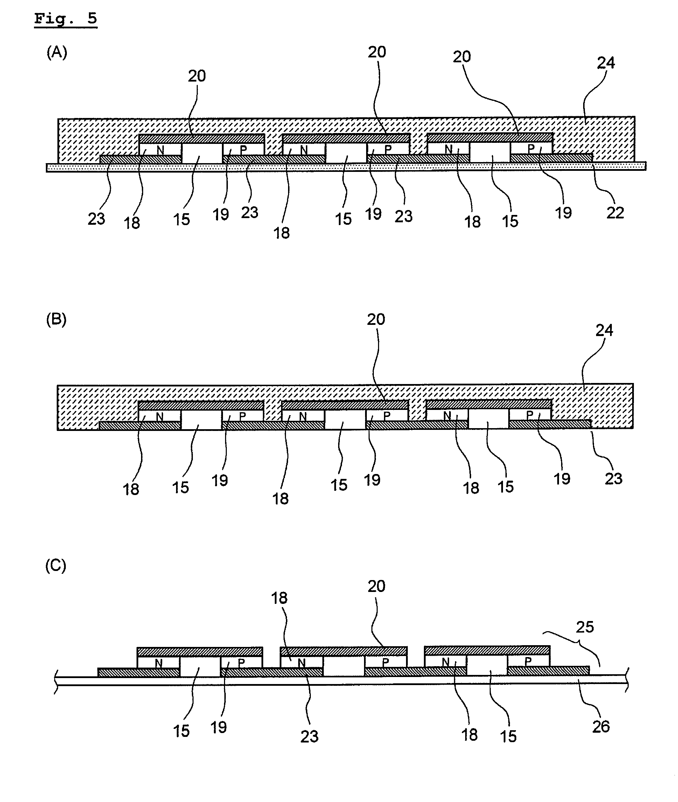

The embodiment using transfer paper is explained hereinafter with reference to Figs 5. First, in the same way as in the embodiment of Figs. 4, each of the synthesized p-type oxide thermoelectric semiconductor element and the n-type oxide thermoelectric semiconductor element is pulverized into powder. The particle diameter of the powder is 0.1 to 10 µm, preferably 0.5 to 3 µm. Metal oxide such as copper oxide (CuO) and bismuth oxide (Bi₂O₃) is added as a binder in the range of 0.5 to 50 mass%, preferably 5 to 40 mass% to each of the thermoelectric semiconductor fine powder. Also, resin such as ethyl cellulose and a solvent such as α-terpineol are added thereto in the appropriate amounts and the mixture was kneaded to be made into paste.

As printing paper, paper the surface of which is coated by a water-soluble resin layer is used. A first electrode film (23) is formed on this paper coated by water-soluble resin (22) as in Fig. 5 (A), and p-type thermoelectric semiconductor element and n-type thermoelectric semiconductor element in paste are formed in a film state by screen printing on the first electrode film in the same way as in the embodiment in Figs. 4. The film thickness is adjusted to 1 to 100 µm and the semiconductor elements may be overprinted twice or more, if desired. Also, as explained in Figs. 3 and Fig. 4, glass paste as a heat insulating layer is screen-printed between the p- and n-type thermoelectric semiconductor element films (18, 19) separated from each other and on the paper coated by resin (22). Subsequently, the second electrode film (20) is screen-printed over each of the glass films (15) so as to bridge the n- and p-type thermoelectric semiconductor element films (18, 19), and then a resin coating (24) is formed thereon.

The laminated body thus supported on the transfer paper is dipped in water so that the water-soluble resin is dissolved and the transfer paper on the underside (22) is peeled off like a film (Fig. 5 (B)). The remaining laminated body (25) is attached on the surface of an object to be sintered (26) and sintered at a temperature of 700°C to 900°C and then the outside resin coating is removed as in Fig. 5 (C). The laminated body in a thin-film state (25) can be attached not only on a flat surface but also on a curved surface of an object, and therefore can be used by being attached on an arbitrary surface such as inner and outer surfaces of a tube-shaped product or a curved surface of a vehicle body.

By arranging a plurality of the above-mentioned band-shaped thermoelectric conversion modules on the same plane and joining the terminal element of each module to another in series, the modules can constitute a planar thermoelectric conversion device.

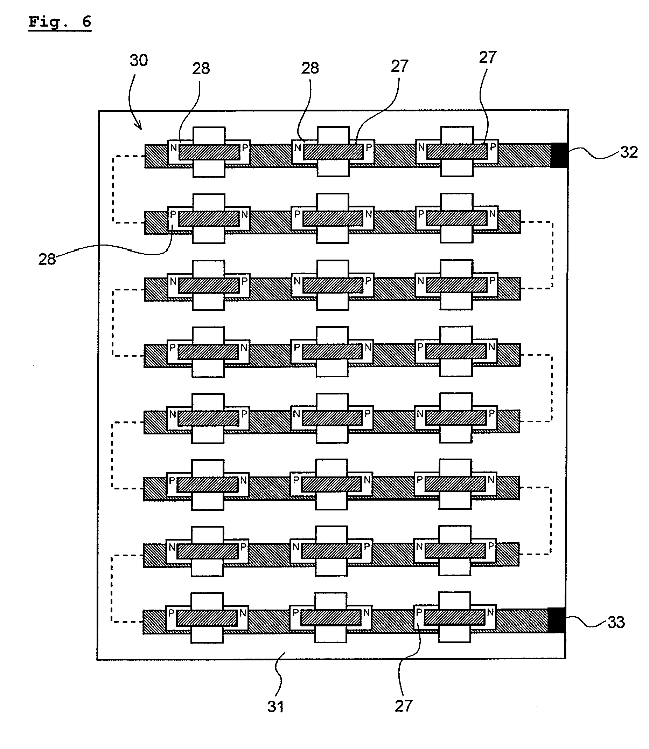

Referring to Fig. 6, eight units of thermoelectric conversion modules (30) are set parallel to each other in a row on a substrate (31), wherein each row comprises three units of p-type thermoelectric semiconductor element films (27) and three units of n-type thermoelectric semiconductor element films (28). The p-type thermoelectric semiconductor element film (27) located at the end of the first row and the n-type thermoelectric semiconductor element film (28) located at the end of the second row are connected via an electrode film. In the same way, the p-type thermoelectric semiconductor element film (27) located at the opposite end of the second row and the n-type thermoelectric semiconductor element film (28) located at the end of the third row are connected via an electrode film. Thus, p-type thermoelectric semiconductor element films (27) located at the end of the second row and the n-type thermoelectric semiconductor element film (28) located at the end of the third row are connected via an electrode film. For the rest of the rows, the p-type thermoelectric semiconductor element film and the n-type thermoelectric semiconductor element film located at the end of each row are connected in series between the rows. Each of the n-type thermoelectric semiconductor element film (28) located at the opposite end of the first row and the p-type thermoelectric semiconductor element film (27) located at the end of the last row is connected to one of a pair of the terminal electrodes (32, 33) at the edge part of the substrate (31).

As mentioned above, by laminating several layers of the planar thermoelectric conversion devices each provided with a plurality of thermoelectric conversion modules on the same plane and joining the terminal electrode of each layer to another, the devices can constitute a three-dimensional thermoelectric conversion device having an even larger capacitance.

## Claims

1. A thermoelectric conversion element obtained by curing a paste prepared by mixing powder of thermoelectric conversion material with a binder in a form of a thin film on the top surface of an electrode.

2. The thermoelectric conversion element as claimed in claim 1, wherein the thermoelectric conversion material is a synthesized oxide thermoelectric semiconductor and is obtained by curing the paste prepared by mixing the powder of the oxide thermoelectric semiconductor adjusted to have a particle size of 0.1 to 10 µm with a metal oxide as a binder at a rate of 0.5 to 50 mass% to the thermoelectric semiconductor into a form of a thin film on the top surface of an electrode.

3. The thermoelectric conversion element as claimed in claim 1 or 2, wherein the film thickness after sintering and curing is 1 to 100 µm.

4. The thermoelectric conversion element as claimed in claim 3, wherein the film thickness after sintering and curing is 10 to 20 µm.

5. A thermoelectric conversion module, comprising first electrode films formed on the top surface of an insulating body, p- and n-type thermoelectric conversion films formed apart from each other on the top surfaces of the first electrode films and second electrode films formed on the top surface of the p- and n-type thermoelectric conversion films, wherein either of the first and the second electrode films is divided between the p- and n-type thermoelectric conversion films.

6. A thermoelectric conversion module, comprising a plurality of first electrode films formed on the top surface of an insulating body, a plurality of p- and n-type thermoelectric conversion films formed alternately and apart from each other on the top surfaces of the first electrode films, and second electrode films which connect p- and n-type thermoelectric conversion element films so as to cross over the gap between the first electrode films, wherein each of p- and n-type thermoelectric conversion element films at the end is connected to a terminal electrode film.

7. The thermoelectric conversion module as claimed in claim 6, wherein a glass film is interposed in the gap between the first electrode films and between the p- and n-type thermoelectric conversion element films facing to the gap.

8. The thermoelectric conversion module as claimed in claim 6 or 7, wherein the p- and n-type thermoelectric conversion element films are the thermoelectric conversion element films made into a thin-film form having a thickness of 1 to 100 µm by curing a paste prepared by mixing the powder of the thermoelectric material with a binder.

9. The thermoelectric conversion module as claimed in claim 8, wherein the p- and n-type thermoelectric conversion element films are the thermoelectric conversion element films made into a thin-film form having a thickness of 10 to 20 µm by curing a paste prepared by mixing the powder of the thermoelectric material with a binder.

10. A method for producing a thermoelectric conversion module comprising a step of forming a plurality of first electrode films apart from each other on the top surface of an insulating body by screen-printing,
a step of forming a glass film in the gap between the first electrode films,
a step of forming p- and n-type thermoelectric conversion element films sandwiching the glass film on the first electrode film by screen-printing,
a step of connecting the top surfaces of the p- and n-type thermoelectric conversion element films with a second electrode film crossing over the glass film by screen-printing, and
a step of forming a terminal electrode film connecting to each of the p- and n-type thermoelectric conversion element films at the end which is not connected by the second electrode film.
